# EUROPÄISCHE PATENTANMELDUNG

(11) **EP 1 816 740 A1**
(43) Veröffentlichungstag der Anmeldung: **08.08.2007**
(21) Anmeldenummer: 07001561.5
(22) Anmeldetag: 25.01.2007
(51) Int. Cl.: H03D 7/14, H03D 7/16

(54) **Integrierte Schaltungsanordnung zum Überführen eines hochfrequenten Bandpasssignals in ein niederfrequentes Quadratursignal**

(30) Priorität: 01.02.2006 DE 102006004951
(71) Anmelder: ATMEL Germany GmbH, 74072 Heilbronn (DE)
(72) Erfinder: Kluge, Wolfram, Dr., 01109 Dresden (DE)

(57) **Zusammenfassung**

Die Erfindung betrifft eine integrierte Schaltungsanordnung zum Überführen eines hochfrequenten Bandpaßsignals in ein niederfrequentes Quadratursignal mit einer ersten Inphase-Komponente und einer ersten Quadraturphasen-Komponente, die folgende Einheiten aufweist: eine Verstärkeranordnung, die zum Generieren eines verstärkten Signals ausgebildet ist und eine erste Verstärkerstufe zum Verstärken des hochfrequenten Bandpaßsignals aufweist, eine Mischereinheit mit einem ersten Mischer zum Bereitstellen der ersten Inphase-Komponente und einem zweiten Mischer zum Bereitstellen der ersten Quadraturphasen-Komponente, und einen Treiberverstärker, der zum Bereitstellen eines lokalen Oszillatorsignals ausgebildet ist. Erfindungsgemäß ist zwischen der Verstärkeranordnung und der Mischereinheit ein Polyphasenfilter angeordnet, das zum Überführen des verstärkten Signals in ein komplexwertiges Polyphasensignal mit einer zweiten Inphase-Komponente und einer zweiten Quadraturphasen-KOrnponente ausgebildet ist. Weiterhin ist jeder Mischer erfindungsgemäß mit dem Treiberverstärker verbunden, wobei der erste Mischer ausgebildet ist, die zweite Inphase-Komponente mit dem lokalen Oszillatorsignal zu multiplizieren, und der zweite Mischer ausgebildet ist, die zweite Quadraturphasen-Komponente mit dem lokalen Oszillatorsignal zu multiplizieren. Die Erfindung betrifft weiterhin eine Sende-/Empfangsvorrichtung mit einer solchen Schaltungsanordnung.

## Beschreibung

Die vorliegende Erfindung betrifft eine integrierte Schaltungsanordnung zum Überführen eines hochfrequenten Bandpaßsignals in ein niederfrequentes Quadratursignal. Die Erfindung betrifft weiterhin eine Sende-/Empfangsvorrichtung mit einer solchen Schaltungsanordnung..

Die Erfindung liegt auf dem Gebiet von Kommunikationssystemen, bei denen eine Vielzahl von Sende-/Empfangsvorrichtungen auf ein bestimmtes Frequenzband bzw. darin enthaltene Trägerfrequenzkanäle zugreifen. Sie liegt insbesondere auf dem Gebiet von integrierten Schaltungen, mit deren Hilfe in solchen Sende-/Empfangsvorrichtungen empfängerseitig ein hochfrequentes Bandpaßsignal, wie z.B. ein über eine Antenne empfangenes Funksignal, in ein niederfrequentes Quadratursignal fester Frequenz überführt (transformiert) wird, bevor die darin enthaltenen, von einer anderen Sende-/Empfangsvorrichtung stammenden Datenwerte detektiert werden.

Wenngleich prinzipiell auf beliebige drahtlose oder drahtgebundene digitale Telekommunikationssysteme anwendbar, werden die vorliegende Erfindung sowie die ihr zugrunde liegende Problematik nachfolgend anhand eines "ZigBee"-Kommunikationssystems gemäß IEEE 802.15.4 erläutert.

Zur drahtlosen Übertragung von Informationen über relativ kurze Distanzen (ca. 10m) können sog. "Wireless Personal Area Networks" (WPANS) verwendet werden. Im Gegensatz zu "Wireless Local Area Networks" (WLANs) benötigen WPANs zur Datenübertragung wenig oder sogar keine Infrastruktur, so daß kleine, einfache, energieeffiziente und kostengünstige Geräte für einen breiten Anwendungsbereich implementiert werden können.

Der Standard IEEE 802.15.4 spezifiziert niederratige WPANs, die mit Rohdatenraten bis 250 kbit/s und ortsfesten oder mobilen Geräten für Anwendungen in der industriellen Überwachung und Steuerung, in Sensornetzwerken, in der Automatisierung, sowie im Bereich der Computerperipherie und für interaktive Spiele geeignet sind. Neben einer sehr einfachen und kostengünstigen implementierbarkeit der Geräte ist für derartige Anwendungen ein extrem geringer Energiebedarf der Geräte von entscheidender Bedeutung. So werden mit diesem Standard Batterielaufzeiten von mehreren Monaten bis zu mehreren Jahren angestrebt.

Auf der Ebene der physikalischen Schicht spezifiziert IEEE 802.15.4 im nahezu weltweit verfügbaren ISM-Band (industrial, scientific, medical) von 2,400 bis 2,483 GHz insgesamt 16 (Trägerfrequenz-)Kanäle mit einem Kanalraster von 5 MHz. Für Rohdatenraten von 250 kbit/s ist in diesen Kanälen eine Symbolrate von 62,5 ksymbol/s und eine Bandspreizung (spreading) mit einer Chiprate von fC=2 Mchip/s sowie eine Offset-QPSK-Modulation vorgesehen (quarternary phase shift keying).

Das in einem der Kanäle des ISM-Bandes übertragene Bandpaß-Funksignal ist empfängerseitig in einer integrierten Schaltungsanordnung, die auch als "HF-Frontend" bezeichnet wird, in ein niederfrequentes Quadratursignal fester Frequenz zu überführen. Das niederfrequente Quadratursignal kann hierbei in einem Zwischenfrequenzbereich (intermediate frequency, IF) oder im Basisbandbereich ("zero IF") liegen. Insbesondere kann es sich um eine im vergleich zur Betriebs-/Trägerfrequenz niedrige Zwischenfrequenz handeln ("low IF"). Das Quadratursignal ist komplexwertig und weist eine Inphase- und eine Quadraturphasen-Komponente auf.

während andere Einheiten des Empfängers erst nach erfolgreicher Synchronisation aktiviert werden müssen, muß das HF-Frontend schon während der sog. Horchphase ("RX Listen Mode") auf die Präambelsequenz aktiv sein. Weiterhin ist der Stromverbrauch bei Baugruppen, die bei Frequenzen im Gigahertzbereich betrieben werden, deutlich höher als bei Baugruppen, die bei niedrigeren Frequenzen betrieben werden. Aus diesen Gründen ist der Energieverbrauch der HF-Frontend-Schaltungsanordnung sehr wichtig für den Energieverbrauch der gesamten Sende-/Empfangsvorrichtung.

Bekannte integrierte HF-Frontend-Schaltungsanordnungen weisen einen rauscharmen Verstärker (low noise amplifier, LNA) sowie einen Quadraturmischer zum spektralen Herabmischen des verstärkten Signals auf. Zum Bereitstellen der Inphase- (I) und der Quadraturphasen-Komponente (Q) des niederfrequenten Quadratursignals enthält der Quadraturmischer, der auch als Spiegelfrequenzunterdrückungsmischer (image reject mixer) bezeichnet wird, zwei aktive Mischer. Die beiden Mischer werden von zwei zueinander um 90 Grad phasenverschobenen Lokaloszillatorsignalen angesteuert, die von zwei Treiberverstärkern bereitgestellt werden. Eine solche Schaltungsanordnung ist beispielsweise aus dem in IEEE Transactions on Microwave Theory and Techniques, Vol. 50, No. 1, (January 2002) erschienenen Artikel "Low-Voltage Low-Power CMOS-RF Transceiver Design" von M.S.J. Steyaert et al. (S. 281-287) bekannt.

Nachteilig sind hierbei der hohe Energieverbrauch im Betrieb und der erhöhte Implementierungsaufwand. Hierzu tragen insbesondere die aktiven Mischer sowie die beiden Treiberverstärker bei.

Vor diesem Hintergrund liegt der Erfindung die Aufgabe zugrunde, eine integrierte HF-Frontend-Schaltungsanordnung anzugeben, die energiesparend zu betreiben und einfach zu implementieren ist, so daß kostengünstig realisierbare, energieeffiziente und leistungsfähige Sende-/Empfangsvorrichtungen ermöglicht werden.

Erfindungsgemäß wird diese Aufgabe gelöst durch eine integrierte Schaltungsanordnung und eine Sende-/Empfangsvorrichtung mit den Merkmalen der Patentansprüche 1 bzw. 16.

Die erfindungsgemäße integrierte Schaltungsanordnung zum Überführen eines hochfrequenten Bandpaßsignals in ein niederfrequentes Quadratursignal mit einer ersten Inphase-Komponente und einer ersten Quadraturphasen-Komponente weist folgende Einheiten auf: a) eine Verstärkeranordnung, die zum Generieren eines verstärkten Signals ausgebildet ist und eine erste Verstärkerstufe zum Verstärken des hochfrequenten Bandpaßsignals aufweist, b) eine Mischereinheit mit einem ersten Mischer zum Bereitstellen der ersten Inphase-Komponente und einem zweiten Mischer zum Bereitstellen der ersten Quadraturphasen-Komponente, c) einen Treiberverstärker (buffer), der zum Bereitstellen eines lokalen Oszillatorsignals ausgebildet ist, und d) ein zwischen der Verstärkeranordnung und der Mischereinheit angeordnetes Polyphasenfilter, das zum Überführen des verstärkten Signals in ein komplexwertiges Polyphasensignal mit einer zweiten Inphase-Komponente und einer zweiten Quadraturphasen-Komponente ausgebildet ist, wobei e) jeder Mischer mit dem Treiberverstärker verbunden ist und der erste Mischer ausgebildet ist, die zweite Inphase-Komponente mit dem lokalen Oszillatorsignal zu multiplizieren, und der zweite Mischer ausgebildet ist, die zweite Quadraturphasen-Komponente mit dem lokalen Oszillatorsignal zu multiplizieren.

Die erfindungsgemäße Sende-/Empfangsvorrichtung weist eine solche Schaltungsanordnung auf.

Das Wesen der Erfindung besteht darin, mit Hilfe des Polyphasenfilters die I/Q-Signalerzeugung *im signalpfad des Empfangssignals* vorzunehmen und in der Mischereinheit die 1- bzw. Q-Komponente des Polyphasensignals mit *demselben* Lokaloszillatorsignal zu multiplizieren. Da nur ein (Nichtquadratur-)Lokaloszillatorsignal erforderlich ist, entfällt die 1/Q-Signalerzeugung im Lokaloszillatorpfad. Hierdurch entfällt vorteilhaft der ansonsten zur Bereitstellung der Q-Komponente des Lokaloszillatorsignals erforderliche zweite Treiberverstärker sowie der hiermit verbundene Energieverbrauch und Realisierungsaufwand. Außerdem entkoppelt das Polyphasenfilter die beiden Mischer vorteilhaft voneinander und vermindert Rückwirkungen, so daß das Rauschen am Ausgang der HF-Frontend-Schaltungsanordnung reduziert wird. Eine solche integrierte HF-Frontend-Schaltungsanordnung ist energiesparend zu betreiben und einfach zu implementieren, so daß einfach und kostengünstig zu implementierende und energiesparend zu betreibende, aber dennoch leistungsfähige Sende-/Empfangsvorrichtungen ermöglicht werden.

Vorteilhafte Ausgestaltungen und Weiterbildungen der Erfindung sind den abhängigen Ansprüchen sowie der Beschreibung unter Bezugnahme auf die Zeichnung zu entnehmen.

In einer ersten, bevorzugten Ausführungsform ist die Mischereinheit passiv ausgestaltet und weist jeder Mischer mindestens einen MOSFET-Transistor mit einem Gate-Anschluss auf, der mit dem Treiberverstärker verbunden ist, so daß der MOSFET-Transistor durch das lokale Oszillatorsignal steuerbar ist. Solche Schaltungsanordnungen weisen einen besonders niedrigen Energieverbrauch auf und sind sehr einfach zu implementieren. Vorteilhaft fließt hierbei kein Gleichstrom durch die Mischereinheit, so daß kein Schrotrauschen (1/f-Rauschen) auftritt. Außerdem weisen MOSFET-Transistoren vorteilhaft eine hohe Großsignalfestigkeit auf, da ihr 1P3-Punkt (intercept point dritter Ordnung) relativ hoch liegt.

In einer weiteren Ausführungsform weist jeder MOSFET-Transistor einen mit dem Polyphasenfilter verbundenen zweiten Anschluss und einen mit einem Operationsverstärker verbundenen dritten Anschluss auf. Die Operationsverstärker sind hierbei vorzugsweise Bestandteil eines mit der Mischereinheit ausgangsseitig verbundenen Filters, insbesondere eines Filters zur Kanalselektion. Hierdurch vereinfacht sich die Realisierung der integrierten Schaltungsanordnung weiter.

In einer weiteren Ausführungsform ist zum Überführen des hochfrequenten Bandpaßsignals in das niederfrequente Quadratursignal genau ein Treiberverstärker vorgesehen. Eine solche Schaltungsanordnung ist sehr einfach zu implementieren und weist einen besonders niedrigen Energieverbrauch auf.

In einer zweiten, bevorzugten Ausführungsform weist das Polyphasenfilter ausschließlich passive, vorzugsweise nur resistive und kapazitive Bauelemente auf. Hierdurch läßt sich ein besonders niedriger Energieverbrauch und eine besonders einfache implementierbarkeit der Schaltungsanordnung und damit der Sende-/Empfangsvorrichtung erreichen.

Vorteilhaft ist das Polyphasenfilter als Polyphasenfilter zweiter Ordnung ausgebildet. Hierdurch läßt sich der Frequenzbereich, in dem das Polyphasenfilter als Bandsperre wirkt, vorteilhaft verbreitern.

Vorteilhaft weist das Polyphasenfilter mindestens zwei Allpaßfilter mit unterschiedlicher Grenzfrequenz auf. Hierdurch läßt sich eine Phasenverschiebung von 90 Grad vorteilhaft in einem breiten Frequenzbereich erreichen.

In einer dritten, bevorzugten Ausführungsform weist die Verstärkeranordnung eine der ersten Verstärkerstufe nachgeschalteten zweite Verstärkerstufe zum Generieren des verstärkten Signals auf und ist ausgestaltet, die beiden verstärkerstufen nach dem Prinzip der Stromwiederverwendung mit Betriebsenergie zu versorgen. Hierdurch können vorteilhaft hohe Verstärkungen ohne erhöhten Energiebedarf erzielt werden. Weiterhin wird hierdurch ermöglicht, die Rauschzahl der HF-Frontend-Schaltungsanordnung zu reduzieren.

Vorzugsweise sind zwischen der Verstärkeranordnung und dem Polyphasenfilter oder/und zwischen dem Polyphasenfilter und der Mischereinheit zur Unterdrückung von Gleichströmen Koppelkondensatoren vorgesehen. Hierdurch tritt vorteilhaft kein Schrot-Rauschen (1/f-Rauschen) auf.

Vorzugsweise weist die Mischereinheit (nur) genau zwei Mischer zum Bereitstellen der ersten Inphase-Komponente und der ersten Quadraturphasen-Komponente auf. Hierdurch lässt sich eine besonders einfache Implementierbarkeit der Schaltungsanordnung und damit der Sende-/Empfangsvorrichtung erreichen.

Die Erfindung wird nachfolgend anhand der in den schematischen Figuren der Zeichnung angegebenen Ausführungsbeispiele näher erläutert. Hierbei zeigen
Fig. 1 ein Beispiel eines "Wireless Personal Area Network" (WPAN) nach IEEE 802.15.4 mit erfindungsgemäßen Sende-/Empfangsvorrichtungen;
Fig. 2 Ausführungsbeispiel einer Empfangseinheit einer Sende-/Empfangsvorrichtung nach IEEE 802.15.4 mit erfindungsgemäßer Schaltungsanordnung;
Fig. 3 Bevorzugte Ausführungsform des Polyphasenfilters einer erfindungsgemäßen Schaltungsanordnung;
Fig. 4 Bevorzugte Ausführungsform der Mischereinheit einer erfindungsgemä-Ben Schaltungsanordnung; und
Fig. 5 Bevorzugte Ausführungsform der Verstärkeranordnung einer erfindungsgemäßen Schaltungsanordnung.

In den Figuren sind gleiche und funktionsgleiche Elemente und Signale - sofern nicht anders angegeben - mit denselben Bezugszeichen versehen.

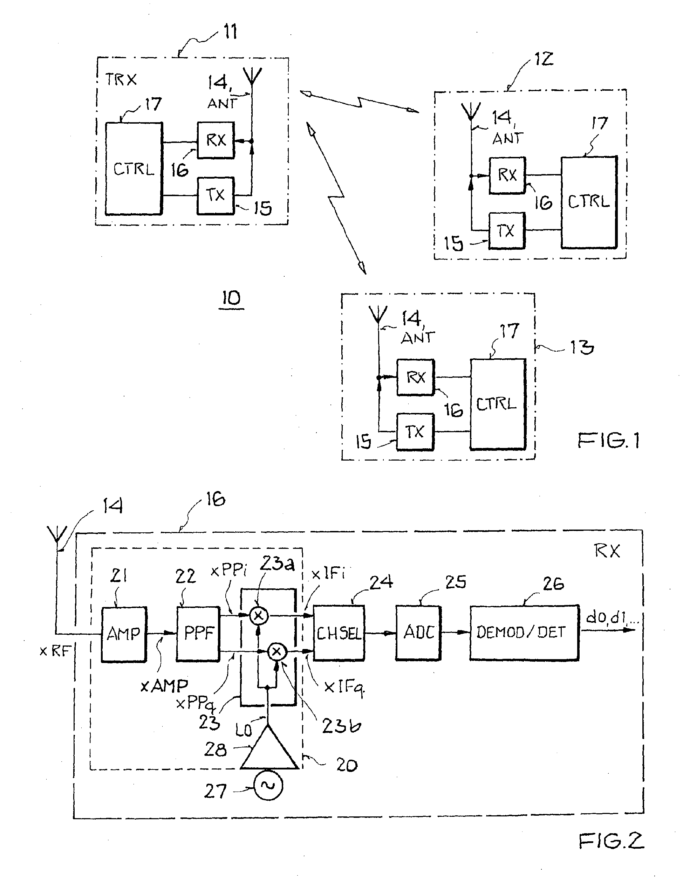

**Figur 1** zeigt ein Beispiel eines "Wireless Personal Area Networks" (WPAN) 10 nach dem IEEE-Standard 802.15.4. Es umfaßt drei Sende-/Empfangsvorrichtungen (transceiver, TRX) 11-13 in Form von ortsfesten oder mobilen Geräten, die mittels Funksignalen drahtlos Informationen austauschen. Bei der Sende-/Empfangsvorrichtung 11 handelt es sich um ein sog. Vollfunktionsgerät, das die Funktion des WPAN-Koordinators übernimmt, während es sich bei den Sende-/Empfangsvorrichtungen 12, 13 um sog. Teilfunktionsgeräte handelt, die dem Vollfunktionsgerät 11 zugeordnet sind und nur mit diesem Daten austauschen können. Neben der in Figur 1 dargestellten sternförmigen Netzwerktopologie, bei der die bidirektionale Datenübertragung nur zwischen jeweils einem der Teilfunktionsgeräte 12, 13 und dem Vollfunktionsgerät 11, nicht jedoch zwischen den Teilfunktionsgeräten 12, 13 erfolgen kann, sieht der Standard auch sog. "Peer-to-Peer"-Topologien vor, bei denen sämtliche Vollfunktionsgeräte mit jeweils allen anderen Vollfunktionsgeräten kommunizieren können.

Die Sende-/Empfangsvorrichtungen 11-13 umfassen jeweils eine Antenne 14, eine mit der Antenne verbundene Sendeeinheit (transmitter, TX) 15, eine mit der Antenne verbundene Empfangseinheit (receiver, RX) 16 und eine mit der Sende- und der Empfangseinheit verbundene Kontrolleinheit (control unit, CTRL) 17 zur Steuerung der Sende- und Empfangseinheiten 15, 16. Weiterhin beinhalten die Sende-/Empfangsvorrichtungen 11-13 jeweils eine in Fig. 1 nicht dargestellte Energieversorgungseinheit in Form einer Batterie etc. zur Energieversorgung der Einheiten 15-17, sowie eventuell weitere Komponenten wie Sensoren etc..

Im folgenden wird davon ausgegangen, daß die Datenübertragung im ISM-Band (industrial, scientific, medical) bei 2,4 GHz erfolgt.

Die Sendeeinheit 15 jeder Sende-/Empfangsvorrichtung wandelt den jeweils zu sendenden Datenstrom gemäß IEEE 802.15.4 in ein über ihre Antenne 14 abzustrahlendes Funksignal um, indem der jeweils zu sendende Datenstrom (Rohdatenrate: 250 kbit/s) zunächst in vier Bit breite Symbole (Symbolrate: 62,5 ksymbol/s) und diese in aufeinanderfolgende symbolwertspezifische PN-Sequenzen (pseudo noise) aus jeweils 32 Chips umgesetzt werden (Chiprate: fC=2 Mchip/s). Die aufeinanderfolgenden PN-Sequenzen werden anschließend Offset-QPSKmoduliert (quarternary phase shift keying), spektral in einen der 16 Kanäle im ISM-Band verschoben und schließlich für die Übertragung verstärkt.

Die Empfangseinheit 16 jeder Sende-/Empfangsvorrichtung wandelt ein von ihrer Antenne 14 empfangenes und von der Sendeeinheit einer zweiten Sende-/Empfangsvorrichtung nach IEEE 802.15.4 erzeugtes Funksignal möglichst fehlerfrei in die gesendeten Daten um, indem das empfangene Funksignal unter anderem verstärkt, in das Basisband transformiert, gefiltert, demoduliert und die Daten detektiert (entschieden) werden.

Die Sendeeinheit 15 und die Empfangseinheit 16 einer Sende-/Empfangsvorrichtung sind hierbei Teil einer in Fig. 1 nicht dargestellten integrierten Schaltung, z.B. eines in einer CMOS-Technologie realisierten ASIC (application specific integrated circuit) oder ASSP (application specific standard product), während die Kontrolleinheit 17 durch einen ebenfalls nicht dargestellten Mikrocontroller realisiert ist. Vorteilhaft weist die Sende-/Empfangsvorrichtung nur eine z.B. als ASIC oder ASSP ausgeführte integrierte Schaltung auf, die die Funktionen der Sendeeinheit 15, der Empfangseinheit 16 und der Kontrolleinheit 17 wahrnimmt.

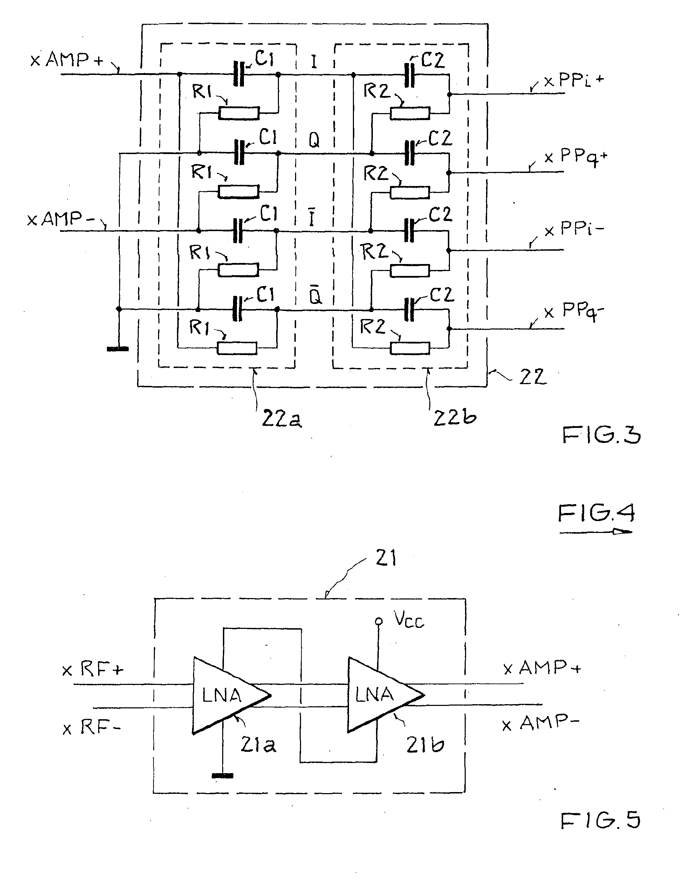

**Figur 2** zeigt ein Blockschaltbild einer exemplarischen Empfangseinheit (RX) 16 mit einer erfindungsgemäßen integrierten Schaltungsanordnung 20.

Die Empfangseinheit 16 beinhaltet folgende in Reihe geschaltete Einheiten: Die mit der Antenne 14 und einem oszillator 27 verbundene Schaltungsanordnung 20, eine analoge Filtereinheit (CHSEL) 24, einen Analog/Digital-Wandler (ADC) 25 und eine digitale Demodulations-/Detektionseinheit (DEMOD/DET) 26.

Die HF-Frontend-SChaltungsanordnung 20 verstärkt das von der Antenne 14 empfangene hochfrequente Bandpaßsignal (Funksignal) xRF, das spektral im ISM-Band liegt, und überführt (transformiert) es in ein relativ niederfrequentes Quadratursignal xIF in einem Zwischenfrequenzbereich beispielsweise um fIF=2 MHz (intermediate frequency, IF). Aufgrund des im Vergleich zur Betriebs- bzw. Trägerfrequenz bei ca. 2,4 GHz niedrigen Wertes der Zwischenfrequenz fIF wird die in Fig. 2 dargestellte Empfangseinheit 16 als "low IF"-Empfangseinheit bezeichnet. Beim niederfrequenten Quadratursignal XIF handelt es sich um ein komplexwertiges Bandpaßsignal, das eine Inphase-Komponente xIFi und eine Quadraturphasen-Komponente xIFq aufweist, die an einem Inphase- bzw. an einem Quadraturphasen-Ausgang der Schaltungsanordnung 20 bereitgestellt werden. Die erfindungsgemäße Schaltungsanordnung 20 kann auch in sog. "zero-IF"-Empfangseinheiten eingesetzt werden, in denen das niederfrequente Quadratursignal ein komplexwertiges Tiefpaßsignal im Basisbandbereich ist.

Die analoge Filtereinheit (CHSEL) 24 ist ausgebildet, ein Bandpaßsignal abzuleiten, indem das niederfrequente Quadratursignal x1F derart gefiltert wird, daß Signalanteile außerhalb des Nutzbandes, d.h. des Nutzkanal-Frequenzbandes unterdrückt werden. Die Filtereinheit 24 dient einerseits der Selektion des gewünschten Kanals (Nutzkanals) bzw. der Unterdrückung von Nachbarkanälen und andererseits der Rauschbandbegrenzung. Hierzu wird die Bandbreite des Quadratursignal xIF in der Filtereinheit 24 mit Hilfe einer komplexen Filterung beschränkt.

Die analoge Filtereinheit 24 umfaßt beispielsweise drei aktive Einseitenband-RC-Resonatoren, die ein 2 MHz breites Bandpassfilter mit einer Butterworth-Charakteristik um eine Mittenfrequenz von 2 MHz ergeben.

Das Ausgangssignal der analogen Filtereinheit 24 wird durch den Analog/Digital-Wandler (ADC) 25 z.B. mit einer Abtastrate von 16 Msps (megasamples per second) abgetastet und mit einer Bitbreite von nur einem Bit quantisiert.

Nach einer nicht in Fig. 2 dargestellten spektralen Verschiebung ins Basisband wird das resultierende Signal in der digitalen Demodulations-/Detektionseinheit (DEMOD/DET) 26 demoduliert, entspreizt und anschließend die ursprünglich gesendeten Datensymbole d0, d1, ... detektiert (entschieden).

Die vorstehend beschriebene Ausgestaltung und Abfolge der Einheiten 24-26 ist exemplarisch zu verstehen.

Beim Oszillator 27 handelt es sich vorzugsweise um einen spannungsgesteuerten Oszillator (voltage controlled oscillator, VCO), dessen Frequenz beispielsweise mit Hilfe einer Phasenregelschleife (PLL) eingestellt wird.

Die integrierte Schaltungsanordnung 20 weist eine Verstärkeranordnung (AMP) 21, ein Polyphasenfilter (PPF) 22, eine Mischereinheit 23 und genau einen Treiberverstärker 28 auf.

Die Verstärkeranordnung 21 ist eingangsseitig mit der Antenne 14 und ausgangsseitig mit dem Polyphasenfilter 22 verbunden. Das Polyphasenfilter 22 ist eingangsseitig mit der Verstärkeranordnung 21 und ausgangsseitig über einen Inphase-(I)-Ausgang und einen Quadraturphasen-(Q)-Ausgang mit der Mischereinheit 23 verbunden. Die Mischereinheit 23 ist eingangsseitig mit dem I- und dem Q-Ausgang des Polyphasenfilters 22 sowie mit dem Treiberverstärker 28 verbunden. Ausgangsseitig ist die Mischereinheit 23 über einen Inphase- und einen Quadraturphasen-Ausgang mit der analogen Filtereinheit 24 verbunden. Der Treiberverstärker 28 ist eingangsseitig mit dem Oszillator 27 und ausgangsseitig mit der Mischereinheit 23 verbunden.

Die Verstärkeranordnung (AMP) 21 generiert ein verstärktes Signal xAMP und weist hierzu mindestens eine rauscharme Verstärkerstufe bzw. einen mindestens einstufigen rauscharmen Verstärker (low noise amplifier, LNA) zum Verstärken des Funksignals xRF auf. Das Nutzsignal wird hierdurch soweit verstärkt, daß nachfolgende Einheiten nur einen geringen Einfluß auf das Signal/Rauschverhältnis haben. Eine bevorzugte Ausführungsform der Verstärkeranordnung 21 ist nachstehend mit Bezug auf Fig. 5 beschrieben.

Das Polyphasenfilter (PPF) 22 überführt das reellwertige verstärkte Signal XAMP in ein komplexwertiges Polyphasen(quadratur)signal xPP mit einer Inphase-Komponente xPPi und einer Quadraturphasen-Komponente xPPq und stellt die Inphase-Komponente xPPi an seinem Inphase-Ausgang und die Quadraturphasen-Komponente xPPq an seinem Quadraturphasen-Ausgang bereit. Die I/Q-Signalerzeugung erfolgt damit im Signalpfad des Empfangssignals.

Das Polyphasensignal xPP repräsentiert das dem verstärkten Signal XAMP zugeordnete analytische Signal xAMP+j*H{XAMP}, wobei H{xAMP} die Hilbert-Transformierte des verstärkten Signals xAMP bezeichnet. Durch das Polyphasenfilter 22 werden bei negativen Frequenzen liegende spektralanteile von XAMP möglichst unterdrückt, während Spektralanteile bei positiven Frequenzen das Polyphasenfilter 22 möglichst unverändert passieren.

Das Polyphasenfilter 22 weist vorzugsweise ausschließlich passive Bauelemente auf und belastet daher nicht die Energieversorgungseinheit (Batterie) der jeweiligen Sende-/Empfangsvorrichtung 11-13 (Fig. 1). Eine bevorzugte Ausführungsform des Polyphasenfilters 22 ist nachstehend mit Bezug auf Fig. 3 beschrieben.

Der Treiberverstärker 28 verstärkt das Ausgangssignal des Oszillators 27 und stellt an seinem Ausgang ein lokales Oszillatorsignal LO bereit. Der Treiberverstärker ist beispielsweise als Buffer ausgeführt.

Zum Überführen des hochfrequenten Bandpasssignals xRF in das niederfrequente Quadratursignal x1F wird genau ein lokales Oszillatorsignal bereitstellt. Neben diesem lokalen Oszillatorsignal LO wird kein weiteres lokales Oszillatorsignal bereitgestellt, insbesondere kein zum Oszillatorsignal LO phasenverschobenes Oszillatorsignal.

Die Mischereinheit 23 verschiebt das hochfrequente Polyphasensignal xPP mit Hilfe des lokalen Oszillatorsignals LO spektral in den Zwischenfrequenzbereich um fIF und stellt die Inphase-Komponente xIFi des resultierenden niederfrequenten Quadratursignals xIF an seinem Inphase-Ausgang und die Quadraturphasen-Komponente xIFq von xIF an seinem Quadraturphasen-Ausgang bereit.

Die Mischereinheit 23 weist einen ersten Mischer 23a und einen zweiten Mischer 23b auf. Eingangsseitig ist der erste Mischer 23a über den Inphase-Eingang der Mischereinheit 23 mit dem Inphase-Ausgang des Polyphasenfilters 22 verbunden, während der zweite Mischer 23b eingangsseitig über den Quadraturphasen-Eingang der Mischereinheit 23 mit dem Quadraturphasen-Ausgang des Polyphasenfilters 22 verbunden ist. Beide Mischer 23a, 23b sind eingangsseitig außerdem jeweils mit dem Ausgang des Treiberverstärkers 28 verbunden. Ausgangsseitig ist der erste Mischer 23a über den inphase-Ausgang der Mischereinheit 23 mit dem Inphase-Eingang der Filtereinheit 24 verbunden, während der zweite Mischer 23b ausgangsseitig über den Quadraturphasen-Ausgang der Mischereinheit 23 mit dem Quadraturphasen-Eingang der Filtereinheit 24 verbunden ist.

Der erste Mischer 23a mischt (multipliziert) die In phase-Komponente xPPi des Polyphasensignals xPP mit dem lokalen Oszillatorsignal LO und stellt die so gebildete Inphase-Komponente xIFi des Quadratursignals xIF am Inphase-Ausgang der Mischereinheit 23 bereit. Analog hierzu mischt (multipliziert) der zweite Mischer 23b die Quadraturphasen-Komponente xPPq des Polyphasensignals xPP mit dem(selben) lokalen Oszillatorsignal LO und stellt die so gebildete Quadraturphasen-Komponente XIFq des Quadratursignals xIF am Quadraturphasen-Ausgang der Mischereinheit 23 bereit.

Zum Bereitstellen der Inphase-Komponente xIFi und der Quadraturphasen-Komponente XlFq weist die Mischereinheit 23 insgesamt nur zwei Mischer 23a, 23b auf, d.h. genau zwei (reellwertige) Mischer.

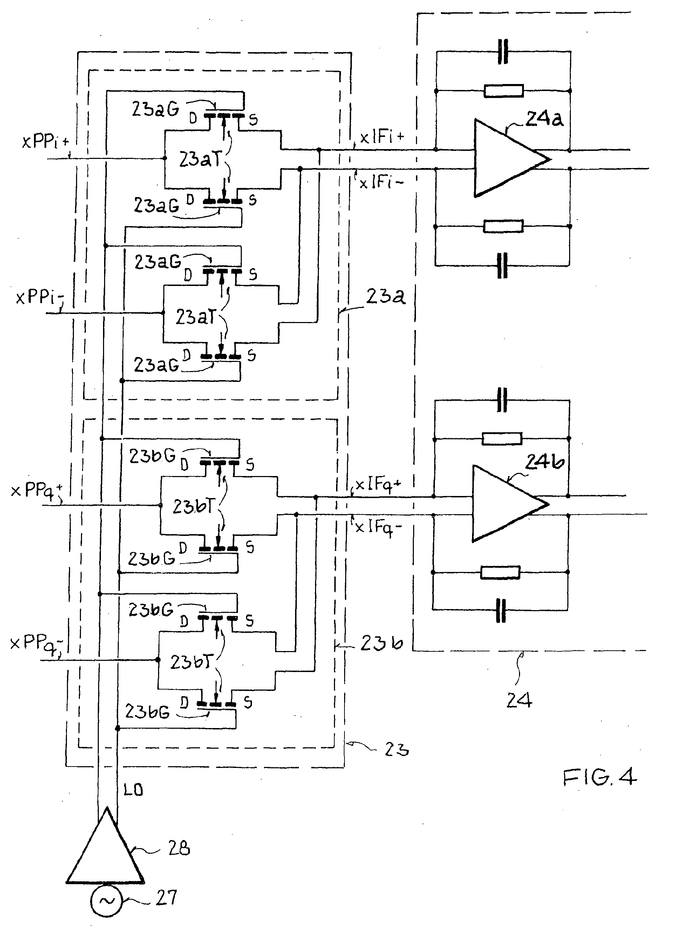

Die beiden Mischer 23a, 23b - und damit die Mischereinheit 23 - sind vorzugsweise passiv ausgestaltet und belasten daher nicht die Energieversorgungseinheit (Batterie) der jeweiligen Sende-/Empfangsvorrichtung 11-13 (siehe Fig. 1). Eine bevorzugte Ausführungsform der Mischereinheit 23 ist nachstehend mit Bezug auf Fig. 4 beschrieben.

Gemäß der vorstehenden Beschreibung erfolgt die I/Q-signalerzeugung im Signalpfad des Empfangssignals XRF, so daß im Signalpfad des lokalen Oszillatorsignals LO keine I/Q-Signalerzeugung erforderlich ist. Daher entfällt vorteilhaft die Erzeugung der Quadraturphasen-Komponente des lokalen Oszillatorsignals und damit auch der ansonsten erforderliche zweite Treiberverstärker zu deren Bereitstellung. Dies ermöglicht leistungsfähige integrierte Frontend-Schaltungsanordnungen 20, die energiesparend zu betreiben und einfach zu implementieren sind.

Vorzugsweise sind zwischen der Verstärkeranordnung 21 und dem Polyphasenfilter 22 (nicht in Fig. 2 dargestellte) Koppelkondensatoren vorgesehen, damit sichergestellt wird, daß kein Gleichstrom über die Mischereinheit 23 fließt. Hierdurch tritt vorteilhaft kein Schrotrauschen (1/f-Rauschen) auf. Alternativ können die Koppelkondensatoren auch zwischen dem Polyphasenfilter 22 und der Mischereinheit 23 angeordnet sein, wobei in diesem Falle doppelt so viele Koppelkondensatoren erforderlich sind.

Die nachfolgend beschriebenen Figuren 3 bis 5 zeigen bevorzugte Ausführungsformen der Verstärkeranordnung 21, des Polyphasenfilters 22 und der Mischereinheit 23. Bei diesen Ausführungsformen wird von differentiellen Signalen ausgegangen, die durch Doppelleitungen gekennzeichnet sind. Selbstverständlich können anstelle von differentiellen Signalen durchgängig oder teilweise nicht-differentielle Signale verarbeitet werden. Solche "single-ended" Realisierungen ergeben sich durch Weglassen derjenigen Schaltungsteile, die die entsprechenden invertierten Signale betreffen.

**Figur 3** zeigt ein Schaltbild einer bevorzugten Ausführungsform des Polyphasenfilters 22 aus Fig. 2.

In diesem Schaltbild ist ein Polyphasenfilter zweiter Ordnung mit einer ersten Stufe 22a und einer zweiten Stufe 22b dargestellt. Jede Stufe umfaßt vier kapazitive Bauelemente C1 bzw. C2 und vier resistive Bauelemente R1 bzw. R2, wobei die Bauelemente jeder Stufe wie dargestellt "ringförmig" verschaltet sind.

Vorzugsweise sind die kapazitiven Bauelemente C1, C2 als Kondensatoren ausgeführt. Alternativ können sie beispielsweise als Varaktor oder als Gate-Bulk-Kapazität eines MOSFET-Transistors ausgebildet sein. Die resistiven Bauelemente R1, R2 sind vorzugsweise als Widerstände ausgeführt. Alternativ können sie z.B. als Drain-Source-Widerstand eines MOSFET-Transistors ausgebildet sein.

Das verstärkte Signal XAMP, das als differentielles Signal ausgebildet ist (s.o.), liegt am differentiellen Inphase-Eingang des Polyphasenfilters an, der in Fig. 3 mit xAMP+ und xAMP- bezeichnet ist. Der differentielle Quadraturphasen-Eingang ist mit Masse (Ground) verbunden. An den differentiellen Inphase- und Quadraturphasen-Ausgängen, die mit xPPi+, xPPi- bzw. xPPq+, xPPq- bezeichnet sind, werden die Inphase-Komponente xPPi bzw. die Quadraturphasen-Komponente xPPq des Polyphasensignals xPP differentiell abgegriffen.

Die Werte der Bauelemente R1, R2, C1, C2 werden so gewählt, daß die beiden Nullstellen des Frequenzgangs des Polyphasenfilters bei Frequenzwerten in der Umgebung der negativen Betriebsfrequenz (-2,44 GHz) liegen. Je weiter die Frequenzwerte der Nullstellen von der negativen Betriebsfrequenz entfernt sind, umso breiter ist der nutzbare Frequenzbereich, umso höher ist aber auch der Amplitudenfehler des Polyphasensignals xPP. Die Bauelemente können beispielsweise wie folgt dimensioniert sein: R1=833 Ohm, R2=1195 Ohm, C1 = C2 = 66,24 fF.

Das in Fig. 3 dargestellte Polyphasenfilter weist ausschließlich passive Bauelemente auf und benötigt daher vorteilhaft keine separate Energieversorgung, so daß die integrierte Schaltungsanordnung 20 aus Fig. 2 mit einem derartigen Polyphasenfilter besonders energieeffizient betrieben werden kann, weiterhin weist das gezeigte Polyphasenfilter ausschließlich resistive und kapazitive Bauelemente (R1, R2, C1, C2) auf, so daß es sehr einfach implementiert werden kann.

Im positiven Frequenzbereich um die Betriebsfrequenz dämpft das gezeigte Polyphasenfilter das Eingangssignal xAMP vorteilhaft relativ schwach. Außerdem entkoppelt das Polyphasenfilter die beiden Mischer 23a, 23b der nachgeschalteten vorzugsweise ebenfalls passiven Mischereinheit 23 (siehe Figuren 2 und 4), so daß Rückwirkungen unter den Mischern vermindert und damit das Rauschen am Ausgang der Schaltungsanordnung/Mischereinheit vorteilhaft reduziert wird.

Anstelle des in Fig. 3 dargestellten Polyphasenfilters *zweiter* Ordnung können auch Polyphasenfilter anderer Ordnungen vorgesehen werden, die nur eine oder aber mindestens drei Stufen aufweisen. Je höher die Ordnung gewählt wird, umso breiter kann der Frequenzbereich gewählt werden, in dem das Polyphasenfilter als Bandsperre wirkt.

Anstelle der in Fig. 3 gezeigten Struktur des Polyphasenfilters können andere Implementierungsarten gewählt werden. Beispielsweise kann das Polyphasenfilter ("Quadraturnetzwerk") zwei Zweige mit je mindestens einem Allpaß erster Ordnung aufweisen, wobei die Allpässe der beiden Zweige unterschiedliche Grenzfrequenzen aufweisen. Auf diese Weise kann vorteilhaft in einem breiten Frequenzbereich eine Phasenverschiebung von 90 Grad zwischen dem Inphase- und dem Quadraturphasen-Ausgang des Polyphasenfilters erreicht werden. Auch diese Implementierungsart mit Allpässen kann rein passiv unter ausschließlicher Verwendung von resistiven und kapazitiven Bauelementen erfolgen.

**Figur 4** zeigt ein Schaltbild einer bevorzugten Ausführungsform der Mischereinheit 23 aus Fig. 2. Die beiden Mischer sind wiederum mit den Bezugszeichen 23a bzw. 23b bezeichnet, während das Bezugszeichen 24 die vorstehend mit Bezug auf Fig. 2 erläuterte analoge Filtereinheit bezeichnet.

Der erste Mischer 23a weist vier MOSFET-Transistoren 23aT mit je einem Source-, einem Drain- und einem Gate-Anschluss auf. Diese vier Transistoren 23aT können in zwei Paare aus jeweils zwei der Transistoren 23aT unterteilt werden, wobei die Drain-Anschlüsse (D) der Transistoren eines Paares miteinander verbunden sind.

Die Drain-Anschlüsse (D) der vier Transistoren 23aT sind über einen differentiellen Eingang des ersten Mischers 23a bzw. den differentiellen Inphase-Eingang der Mischereinheit 23, der in Fig. 4 mit xPPi+, xPPi- bezeichnet ist, mit dem gleichnamigen Inphase-Ausgang des Polyphasenfilters 22 verbunden (siehe Fig. 3), wobei die Drain-Anschlüsse des in Fig. 4 oben dargestellten ersten Transistorpaares mit dem nicht-invertierten Ausgang xPPi+ verbunden sind, während die Drain-Anschlüsse des in Fig. 4 darunter dargestellten zweiten Transistorpaares des Mischers 23a mit dem invertierten Ausgang xPPi- verbunden sind.

Die Source-Anschlüsse (S) der Transistoren 23aT sind über einen differentiellen Ausgang des ersten Mischers 23a bzw. den differentiellen Inphase-Ausgang der Mischereinheit 23, der in Fig. 4 mit xlFi+, xIFi- bezeichnet ist, und über den Inphase-Eingang der Filtereinheit 24 mit einem Operationsverstärker 24a verbunden. Hierbei sind die Source-Anschlüsse des "oberen" Transistors des ersten Paares und des "unteren" Transistors des zweiten Paares miteinander und mit dem nicht-invertierten Ausgang xlFi+ verbunden, während die Source-Anschlüsse des "unteren" Transistors des ersten Paares und des "oberen" Transistors des zweiten Paares miteinander und mit dem invertierten Ausgang xIFi- verbunden sind.

Der zweite Mischer 23b weist ebenfalls vier MOSFET-Transistoren 23bT auf, die gemäß Fig. 4 analog zu den Transistoren 23aT des ersten Mischers 23a verschaltet sind und Drain-seitig mit dem differentiellen Quadraturphasen-Eingang xPPq+, xPPq- sowie Source-seitig mit dem differentiellen Quadraturphasen-Ausgang xlFq+, xIFq- der Mischereinheit 23 verbunden sind.

Die Inphase-Komponente xPPi des Polyphasensignals xPP, die als differentielles Signal ausgebildet ist, liegt am differentiellen Inphase-Eingang xPPi+, xPPi- der Mischereinheit 23 an, während die Quadraturphasen-Komponente xPPq am differentiellen Quadraturphasen-Eingang xPPq+, xPPq- anliegt. An den differentiellen Inphase- und Quadraturphasen-Ausgängen xlFi+, xIFi- bzw. xIFq+, xIFq- der Mischereinheit werden die Inphase-Komponente xIFi bzw. die Quadraturphasen-Komponente xIFq des Quadratursignals xIF differentiell abgegriffen.

Die Gate-Anschlüsse 23aG, 23bG der Transistoren 23aT, 23bT beider Mischer 23a, 23b sind mit dem Treiberverstärker 28 verbunden, so daß sämtliche Transistoren 23aT, 23bT durch das lokale Oszillatorsignal LO gesteuert werden.

Wie aus Fig. 4 zu erkennen ist, sind die Mischer 23a und 23b, die die inphase-Komponente xPPi bzw. die Quadraturphasen-Komponente xPPq des Polyphasensignals xPP mit dem lokalen Oszillatorsignal LO mischen (multiplizieren), passiv realisiert. Dabei werden die MOSFET-Transistoren 23aT, 23bT als steuerbare Widerstände verwendet, wobei sich die Widerstände der Drain-Source-Kariäle im Takt des lokalen Oszillatorsignals LO ändern. Die beiden Mischer 23a, 23b arbeiten jeweils auf eine niederohmige Last, die vorzugsweise durch einen Operationsverstärker 24a, 24b gebildet wird, der als Bestandteil der nachgeschalteten analogen Filtereinheit 24 ohnehin vorgesehen ist. In der Mischereinheit sind daher keine zusätzlichen diesbezüglichen Schaltungskomponenten erforderlich.

Die in Fig. 4 dargestellte Mischereinheit 23 ist passiv ausgestaltet und benötigt daher vorteilhaft keine separate Energieversorgung, so daß die integrierte Schaltungsanordnung 20 aus Fig. 2 mit einer derartigen Mischereinheit besonders energieeffizient betrieben werden kann. Durch die Mischer fließt vorteilhaft kein Gleichstrom, so daß kein Schrotrauschen (1/f-Rauschen) auftritt. Weiterhin weist diese Mischereinheit ausschließlich MOSFET-Transistoren auf, die sich durch eine hohe Großsignalfestigkeit auszeichnen, da ihr 1P3-Punkt (intercept point dritter Ordnung) relativ hoch liegt. Die integrierte Schaltungsanordnung 20 mit einer solchen Mischereinheit kann sehr einfach implementiert werden.

Die Drain- und Source-AnSChlüsse der MOSFET-Transistoren 23aT, 23bT können im Vergleich zum in Fig. 4 gezeigten Schaltbild alternativ vertauscht werden, so daß die Source-Anschlüsse (S) mit den Eingängen der Mischereinheit und die Drain-Anschlüsse (D) mit den Ausgängen verbunden sind.

Das in Figur 4 gezeigte Schaltbild der Mischereinheit 23 vereinfacht sich, wenn an den Eingängen und/oder an den Ausgängen der Mischereinheit nicht-differentielle Signale verwendet werden. Wird beispielsweise eingangsseitig ein nicht-differentielles Polyphasensignal verwendet, so entfallen im Vergleich zum Schaltbild gemäß Fig. 4 die invertierten Eingänge xPPi-, xPPq- der Mischereinheit und das jeweils "untere" Transistorpaar jedes Mischers. Wird ausgangsseitig ein nicht-differentielles Quadratursignal x1F verwendet, so entfallen zusätzlich oder ausschließlich die invertierten Ausgänge XIFi-, XIFq- der Mischereinheit und damit der "untere" Transistor des "oberen" Paares und der "obere" Transistor des "unteren" Paares jedes Mischers. Auf diese Weise ergeben sich Mischereinheiten, deren Mischer unterschiedliche Anzahlen von Transistoren aufweisen: Werden nicht-differentielle Ein- *und* Ausgänge verwendet, so weist jeder Mischer nur einen MOSFET-Transistor 23aT, 23bT auf. Sind dagegen nicht-differentielle Eingänge und differentielle Ausgänge oder umgekehrt differentielle Eingänge und nicht-differentielle Ausgänge vorgesehen, so weist jeder Mischer zwei MOSFET-Transistoren auf. Die in Fig. 4 dargestellten vier MOSFET-Transistoren pro Mischer ergeben sich im bevorzugten Falle differentieller Ein- *und* Ausgänge.

Anstelle der in Fig. 4 gezeigten N-Kanal MOSFET-Transistoren können auch P-Kanal MOSFET-Transistoren verwendet werden. Anstatt von "enhancement mode" Transistoren können alternativ "depletion mode" Transistoren verwendet werden. Schließlich können auch Dioden anstelle der MOSFET-Transistoren verwendet werden.

Werden sowohl die Mischereinheit 23 als auch das Polyphasenfilter 22 gemäß der vorstehenden Beschreibung mit Bezug auf die Figuren 3 und 4 passiv realisiert, so tragen ausschließlich die Verstärkeranordnung 21 und der Treiberverstärker 28 zum Energieverbrauch der Schaltungsanordnung 20 aus Fig. 2 bei. Auf diese weise können besonders energieeffiziente und einfach zu implementierende HF-Frontend-Schaltungsanordnungen und damit Sende-/Empfangsvorrichtungen realisiert werden.

**Figur 5** zeigt ein Blockschaltbild einer bevorzugten Ausführungsform der Verstärkeranordnung 21 aus Fig. 2.

Die Verstärkeranordnung 21 weist einen ersten rauscharmen Verstärker (LNA) 21a und vorzugsweise einen nachgeschalteten zweiten rauscharmen Verstärker (LNA) 21b auf. Der erste Verstärker 21a bildet die erste Stufe der kaskadierten Verstärkeranordnung 21 und der zweite Verstärker 21b die zweite Stufe. Beide Verstärkerstufen sind vorzugsweise differentiell ausgebildet.

Die erste Verstärkerstufe 21a ist eingangsseitig mit dem differentiellen Eingang xRF+, xRF- der Verstärkeranordnung 21 verbunden, dem das Funksignal XRF zugeführt wird. Die zweite Verstärkerstufe 21b ist ausgangsseitig mit dem differentiellen Ausgang xAMP+, xAMP- der Verstärkeranordnung 21 verbunden, an dem das verstärkte Signal xAMP anliegt.

Die zweite Stufe 21b erhöht die Gesamtverstärkung des Funksignals XRF. Dies ist insbesondere dann vorteilhaft, wenn sowohl die Mischereinheit 23 als auch das Polyphasenfilter 22 passiv realisiert sind (siehe z.B. Fig. 3, 4) und ein hoher Gesamtverstärkungsfaktor erforderlich ist. In diesem Falle wird durch die erhöhte Gesamtverstärkung in der Verstärkeranordnung 21 die durch das passive Polyphasenfilter 22 und die passive Mischereinheit 23 verursachte Signaldämpfung kompensiert, so daß die HF-Frontend-Schaltungsanordnung 20 vorteilhaft eine niedrigere Rauschzahl erreicht.

Wie aus Fig. 5 zu erkennen ist, werden beide Verstärkerstufen 21a, 21b nach dem Prinzip der Stromwiederverwendung (current reuse) mit Betriebsenergie versorgt. Hierzu ist der Masseanschluss der zweiten Verstärkerstufe 21b mit dem Betriebsspannungsanschluss der ersten Stufe 21a verbunden, während am Betriebsspannungsanschluss der zweiten Stufe 21b die Versorgungsspannung Vcc anliegt und der Masseanschluss der ersten Stufe 21a mit Masse verbunden ist. Beide Verstärkerstufen werden hierdurch vom gleichen Betriebsstrom gespeist. Ein zusätzlicher Strombedarf entsteht daher durch die zweite Stufe 21b nicht. Jeder Verstärkerstufe 21a, 21b steht hierbei nur ein Teil der Versorgungsspannung Vcc zur Verfügung, wobei die verminderte Versorgungsspannung für den Betrieb jeder einzelnen Stufe ausreicht. Alternativ zur in Fig. 5 dargestellten Ausführungsform kann auch der Masseanschluss der *ersten* Stufe mit dem Betriebsspannungsanschluss der *zweiten* Stufe verbunden sein, um das Prinzip der Stromwiederverwendung zu realisieren.

Beide Verstärkerstufen 21a, 21b sind vorzugsweise in einer Common-Source-Konfiguration implementiert, wobei der Ausgang der ersten Stufe kapazitiv mit dem Eingang der zweiten Stufe gekoppelt ist. Alternativ kann eine der Verstärkerstufen oder aber beide Stufen in einer Common-Gate- oder einer Kaskode-Konfiguration realisiert sein.

Die vorstehend mit Bezug auf die Figuren 2 bis 5 beschriebene integrierte HF-Frontend-Schaltungsanordnung ist sehr einfach zu implementieren und besonders energiesparend zu betreiben. Sie ermöglicht damit kostengünstig realisierbare, energieeffiziente und leistungsfähige Sende-/Empfangsvorrichtungen.

von der Anmelderin in einer CMOS-Technologie (0,18µm) realisierte voll integrierte IEEE 802.15.4-konforme Transceiver für das ISM-Band weisen eine erfindungsgemäße schaltungsanordnung auf, deren Stromverbrauch (inkl. LO-Treiberverstärker) ca. 3,5mA beträgt. Die HF-Frontend-Schaltungsanordnung belegt eine Chipfläche von ca. 300µm x 800µm und erfüllt sämtliche Anforderungen bzgl. der zu erreichenden Verstärkung, Rauschzahl (noise figure), Großsignalfestigkeit (IP3, Sättigung), Spiegelfrequenzunterdrückung etc..

Obgleich die vorliegende Erfindung vorstehend anhand von Ausführungsbeispielen beschrieben wurde, ist sie nicht darauf beschränkt, sondern auf vielfältige Weise modifizierbar. So ist die Erfindung beispielsweise weder auf WPANs an sich, noch auf WPANs gemäß IEEE 802.15.4 bzw. die dort spezifizierten Frequenzbänder, Kanalraster, Sendeleistungen, Empfängerempfindlichkeiten etc., noch auf die angegebenen Werte der Zwischenfrequenz, FilterordnLingeh, Bauteile etc. beschränkt. Die Erfindung kann vielmehr in unterschiedlichsten drahtlosen oder -gebundenen digitalen Kommunikationssystemen vorteilhaft eingesetzt werden.

### Bezugszeichenliste

- 10: Datenübertragungssystem / WPAN nach IEEE 802.15.4
- 11-13: Sende-/Empfangsvorrichtung, "transceiver"
- 14: Antenne
- 15: Sendeeinheit, "transmitter"
- 16: Empfangseinheit, "receiver"
- 17: Kontrolleinheit
- 20: Integrierte Schaltungsanordnung
- 21: Verstärkeranordnung
- 21a,21b: erste bzw. zweite Verstärkerstufe
- 22: Polyphasenfilter
- 22a, 22b: erste Stufe bzw. zweite Stufe des Polyphasenfilters
- 23: Mischereinheit
- 23a, 23b: erster bzw. zweiter Mischer
- 23aG, 23bG: Gate-Anschlüsse
- 23aT, 23bT: MOSFET-Transistoren
- 24: Filter; Kanalselektionsfilter
- 24a, 24b: Operationsverstärker
- 25: Analog-/Digital-Wandler
- 26: Demodulations-/Detektionseinheit
- 27: Oszillator, VCO
- 28: Treiberverstärker, Buffer, Treiberschaltung,

- ADC: analog to digital converter (Analog-/Digital-Wandler)
- AMP: Verstärkeranordnung
- CHSEL: Filter; Kanalselektionsfilter
- CMOS: complementary metal oxide semiconductor
- CTRL: Kontrolleinheit
- DEMOD/DET: Demodulations-lDetektionseinheit
- HF: Hochfrequenz
- IC: Integrierte Schaltung; Chip
- IF: intermediate frequency (Zwischenfrequenz)
- 1P3: intercept point dritter Ordnung
- ISM: industrial, scientific, medical (Frequenzband bei 2,4 GHz)
- LNA: low noise amplifier (rauscharmer Verstärker)
- LO: lokales Oszillatorsignal
- MOSFET: metal oxide semiconductor field effect transistor
- PN: pseudo-noise
- PP: polyphase
- PPF: Polyphasenfilter
- QPSK: quarternary phase shift keying
- RX: Empfangseinheit, receiver
- TRX: sende-/Empfangsvorrichtung, transceiver
- TX: Sendeeinheit, transmitter
- VCO: voltage controlled oscillator (spannungsgesteuerter Oszillator)
- WPAN: Wireless Personal Area Network

- C1, C2: kapazitive Bauelemente, Kondensatoren
- d0, d1, d2, ...: Datensymbole
- fB: Bitrate
- fC: Chiprate
- I, Q: Inphase- bzw. Quadraturphasen-Komponente eines Signals
- LO: lokales Oszillatorsignal
- R1, R2: resistive Bauelemente, Widerstände
- xAMP: verstärktes Signal
- xIF: niederfrequentes Quadratursignal
- xIFi, xIFq: Inphase- bzw. Quadraturphasen-Komponente von xIF
- xPP: Polyphasensignal
- xPPi, xPPq: Inphase- bzw. Quadraturphasen-Komponente von xPP
- xRF: hochfrequentes Bandpaßsignal, Empfangssignal, Funksignal
- Vcc: versorgungsspannung

## Patentansprüche

1. Integrierte Schaltungsanordnung (20) zum Überführen eines hochfrequenten Bandpaßsignals (xRF) in ein niederfrequentes Quadratursignal (xIF) mit einer ersten Inphase-Komponente (XIFi) und einer ersten Quadraturphasen-Komponente (xlFq), enthaltend:
a) eine Verstärkeranordnung (21), die zum Generieren eines verstärkten Signals (xAMP) ausgebildet ist und eine erste Verstärkerstufe (21a) zum Verstärken des hochfrequenten Bandpaßsignals (xRF) aufweist,
b) eine Mischereinheit (23) mit einem ersten Mischer (23a) zum Bereitstellen der ersten Inphase-Komponente (xIFi) und einem zweiten Mischer (23b) zum Bereitstellen der ersten Quadraturphasen-Komponente (xIFq), und
c) einen Treiberverstärker (28), der zum Bereitstellen eines lokalen oszillatorsignals (LO) ausgebildet ist,
**dadurch gekennzeichnet, dass**
d) zwischen der Verstärkeranordnung (21) und der Mischereinheit (23) ein Polyphasenfilter (22) angeordnet ist, das zum Überführen des verstärkten Signals (xAMP) in ein komplexwertiges Polyphasensignal (XPP) mit einer zweiten Inphase-Komponente (xPPi) und einer zweiten Quadraturphasen-Komponente (xPPq) ausgebildet ist,
e) jeder Mischer (23a, 23b) mit dem Treiberverstärker (28) verbunden ist, wobei der erste Mischer (23a) ausgebildet ist, die zweite Inphase-Komponente (xPPi) mit dem lokalen Oszillatorsignal (LO) zu multiplizieren, und der zweite Mischer (23b) ausgebildet ist, die zweite Quadraturphasen-Komponente (xPPq) mit dem lokalen Oszillatorsignal (LO) zu multiplizieren.

2. integrierte Schaltungsanordnung nach Anspruch 1, **dadurch gekennzeichnet, dass** die Mischereinheit (23) passiv ausgestaltet ist und jeder Mischer (23a, 23b) mindestens einen MOSFET-Transistor (23aT, 23bT) mit einem Gate-Anschluss (23aG, 23bG) aufweist, der mit dem Treiberverstärker (28) verbunden ist, so dass der MOSFET-Transistor (23aT, 23bT) durch das lokale Oszillatorsignal (LO) steuerbar ist.

3. Integrierte Schaltungsanordnung nach Anspruch 2, **dadurch gekennzeichnet, dass** jeder MOSFET-Transistor (23aT, 23bT) einen mit dem Polyphasenfilter (22) verbundenen zweiten Anschluss und einen mit einem Operationsverstärker (24a, 24b) verbundenen dritten Anschluss aufweist.

4. Integrierte Schaltungsanordnung nach Anspruch 3, wobei die Operationsverstärker (24a, 24b) Bestandteil eines mit der Mischereinheit (23) ausgangsseitig verbundenen Filters (24) sind, insbesondere eines Filters zur Kanalselektion.

5. Integrierte Schaltungsanordnung nach einem der vorhergehenden Ansprüche, **dadurch gekennzeichnet, dass** zum Überführen des hochfrequenten Bandpaßsignals (XRF) in das niederfrequente Quadratursignal (x1F) genau ein Treiberverstärker (28) vorgesehen ist.

6. Integrierte Schaltungsanordnung nach einem der vorhergehenden Ansprüche, **dadurch gekennzeichnet, dass** das Polyphasenfilter (22) ausschließlich passive Bauelemente aufweist.

7. Integrierte Schaltungsanordnung nach Anspruch 6, **dadurch gekennzeichnet, dass** das Polyphasenfilter (22) nur resistive und kapazitive Bauelemente (R1, R2, C1, C2) aufweist.

8. Integrierte Schaltungsanordnung nach einem der vorhergehenden Ansprüche, **dadurch gekennzeichnet, dass** das Polyphasenfilter (22) als Polyphasenfilter zweiter Ordnung (22a, 22b) ausgebildet ist.

9. integrierte Schaltungsanordnung nach einem der vorhergehenden Ansprüche, **dadurch gekennzeichnet, dass** das Polyphasenfilter (22) mindestens zwei Allpaßfilter mit unterschiedlicher Grenzfrequenz aufweist.

10. integrierte Schaltungsanordnung nach einem der vorhergehenden Ansprüche, **dadurch gekennzeichnet, dass** die Verstärkeranordnung (21) eine der ersten Verstärkerstufe (21a) nachgeschaltete zweite Verstärkerstufe (21b) zum Generieren des verstärkten Signals (xAMP) aufweist und ausgestaltet ist, die beiden Verstärkerstufen (21a, 21b) nach dem Prinzip der Stromwiederverwendung mit Betriebsenergie zu versorgen.

11. Integrierte Schaltungsanordnung nach einem der vorhergehenden Ansprüche, **dadurch gekennzeichnet, dass** zwischen der Verstärkeranordnung (21) und dem Polyphasenfilter (22) oder/und zwischen dem Polyphasenfilter (22) und der Mischereinheit (23) zur Unterdrückung von Gleichströmen Koppelkondensatoren vorgesehen sind.

12. Integrierte Schaltungsanordnung nach einem der vorhergehenden Ansprüche, wobei das hochfrequente Bandpaßsignal (xRF) Frequenzanteile im Gigahertzbereich aufweist.

13. Integrierte Schaltungsanordnung nach einem der vorhergehenden Ansprüche, wobei das niederfrequente Quadratursignal (xIF) Frequenzanteile im Megahertzbereich aufweist.

14. Integrierte Schaltungsanordnung nach einem der vorhergehenden Ansprüche, **dadurch gekennzeichnet, dass** die Mischereinheit (23) genau zwei Mischer (23a, 23b) zum Bereitstellen der ersten Inphase-Komponente (xIFi) und der ersten Quadraturphasen-Komponente (xIFq) aufweist.

15. integrierte Schaltungsanordnung nach einem der vorhergehenden Ansprüche, **dadurch gekennzeichnet, dass** der erste Mischer (23a) ausgebildet ist, die erste Inphase-Komponente (xIFi) bereitzustellen, indem er die zweite Inphase-Komponente (xPPi) mit dem lokalen Oszillatorsignal (LO) multipliziert, und der zweite Mischer (23b) ausgebildet ist, die erste Quadraturphasen-Komponente (xIFq) bereitzustellen, indem er die zweite Quadraturphasen-Komponente (xPPq) mit dem lokalen Oszillatorsignal (LO) multipliziert.

16. Sende-/Empfangsvorrichtung (11-13), insbesondere für ein Datenübertragungssystem (10) nach dem IEEE-Standard 802.15.4, beinhaltend eine Antenne (14) und eine mit der Antenne verbundene Empfangseinheit (16) mit einer integrierten Schaltungsanordnung (20) nach einem der Ansprüche 1 bis 15.
